Europäisches Patentamt

European Patent Office

Office européen des brevets

(19)

(11) Publication number: 0 179 365

A2

(12) **EUROPEAN PATENT APPLICATION**

(21) Application number: 85112903.1

(22) Date of filing: 11.10.85

(51) Int. Cl.⁴: **H01L 21/76** , H01L 21/312

(30) Priority: 25.10.84 US 664633

(43) Date of publication of application:
30.04.86 Bulletin 86/18

(84) Designated Contracting States:
DE FR GB

(71) Applicant: International Business Machines Corporation
Old Orchard Road
Armonk, N.Y. 10504(US)

(72) Inventor: Cheng, Ying Ying
6807 Trinidad Drive
San Jose California 95 120(US)
Inventor: Dawson. Daniel Joseph
P.O. Box 1033
Menlo Park California 94 026(US)
Inventor: Economy, James
6694 Heathfield Drive
San Jose California 95 120(US)
Inventor: Swanson, Sally Ann
1566 Ballantree Way
San Jose California 95 118(US)
Inventor: Twieg, Robert James
1027 Lincoln Court
San Jose California 95 125(US)

(74) Representative: Kreidler, Eva-Maria, Dr. rer. nat.
Schönaicher Strasse 220
D-7030 Böblingen(DE)

(54) Process for filling deep dielectric isolation trenches in semiconductor devices.

(57) Deep dielectric isolation trenches in semiconductor devices filled by a process using a filtered solution of a polyaromatic oligomer with reactive ethynyl groups, said solution having a viscosity of between $2 \times 10^{-6}$ and $2 \times 10^{-3}$ m²/s.

EP 0 179 365 A2

PROCESS FOR FILLING DEEP DIELECTRIC ISOLATION TRENCHES IN SEMICONDUCTOR DEVICES

The present invention is concerned with a process for filling deep dielectric isolation trenches in semiconductor devices and with devices prepared by the process.

A new approach in improved semiconductor devices depends upon the use of deep dielectric isolation trenches to achieve much higher densities as well as higher speeds. Such trenches can be filled with polyimide resin or polysilicon. See Japan Institute of Invention and Innovation: Technical Disclosure No. 58-138049, page 46. See also IBM Technical Disclosure Bulletin Vol. 25 No. 12, May 1983, pp 6611-6614.

U.S. Patent 4,339,526 shows the use of an acetylene-terminated branched polyphenylene prepolymer as a protective coating for an integrated circuit device. The patent, however, does not discuss the concept of filling deep dielectric isolation trenches and it does not teach the process of the present invention.

According to the present invention, deep dielectric isolation trenches in a semiconductor device are filled by a process comprising the steps of dissolving a polyaromatic oligomer with reactive ethynyl groups in a solvent to form a solution of controlled viscosity. This solution is then filtered through a very fine filter, and then used for coating the trench-containing semiconductor device with a film. Upon heating the device, solvent is evaporated and the film is cured. When the solvent is evaporated, but before the sample cures, the oligomer melts, flows and fills the trenches in the temperature range of 80-125°C, but as low as ambient conditions to as high as 160°C. It then polymerizes by the reaction of the ethynyl groups at higher temperatures.

In development of semiconductor devices incorporating dielectric isolation trenches (about 1 to 2 μm in width and about 5 μm in depth) - a number of problems have been identified with the use of polyimides or polysilicon. The polyimides used in the prior art do not completely fill these trenches. Furthermore, the polyimides absorb solvents, water and gases which greatly complicates subsequent processing. Polyimides are soluble in only a limited number of solvents and usually require an adhesion promoter. Their curing involves the evolution of volatile products. The cured polyimides swell in many processing solvents and their planarization is limited. The polysilicon also used in the prior art requires a very expensive vapor deposition step, creates localized stresses and also has the disadvantage of not being a very good electric insulator. The materials of the present invention overcome all these disadvantages of the prior art.

For use in the present invention, the trench filling material is a polyaromatic oligomer with reactive ethynyl groups. These materials are known to the prior art and are derived from a number of different monomers including triethynylbenzene (TEB), diethynyldiphenylether (DEDPE), and phenylacetylene (PA). Other useful aromatic acetylene containing monomers are listed, for example, in U.S. patent 4,097,460.

One of the advantages of the present process is that it is suitable for use with any of many solvents. Initially, the oligomer is dissolved in a solvent and applied to the semiconductor device by spin-coating. Useful solvents include, for example, N-methyl pyrrolidinone, xylenes, diglyme, mesitylene, diethylbenzene, propylene glycol monomethyl ether acetate, tetraglyme, isophorone, veratrole, m-dimethoxybenzene, butyrolactone, toluene, chloroform, dioxane and dichloromethane.

In the coating process the viscosity of the solution should be controlled so that complete filling of the trenches is obtained. The viscosity is controlled in two ways. One, by controlling the ratio of solvent to solute; the more dilute the solution, the less viscous it is, and two, by controlling the molecular weight of the oligomer; the lower the molecular weight, the lower the viscosity. In general, the viscosity of the solution is preferably on the order of about $2 \times 10^{-6}$ to $3 \times 10^{-4}$ m2/s. When the viscosity is above about $2 \times 10^{-3}$ m2/s complete filling does not occur, particularly in the corners of the trenches. When the viscosity is below about $2 \times 10^{-6}$ m2/s it is difficult to develop uniform coherent trench fillings.

It is important that the oligomer solution be filtered before the coating operation. The presence of even minute amounts of suspended particles could be a serious contaminant to the semiconductor device. Such filtration can readily be obtained using, for example, a 0.5μm filter.

Evaporation of the solvent is readily obtained by simple application of heat and, in like manner, the coating films are cured by the application of heat.

By the process of the present invention, outstandingly good results have been obtained in complete filling of the trenches. The filling material is thermally stable up to 400°C with no decomposition or evolution of volatiles.

EXAMPLES

Example 1

The monomer, diethynyldiphenylether (DEDPE) (825 mmoles), is placed into a four-necked one liter round bottomed flask. Nickel 2,4-pentanedionate (4.16 mmoles) and triphenylphosphine (11.6 mmoles) are then added and are washed in with phenylacetylene (1320 mmoles) and dioxane (301 ml). The flask is equipped with a matched pair of reflux condensers, nitrogen and vacuum inlets and vacuum regulator, overhead stirrer, heating mantle and thermocouple. The contents are stirred under nitrogen until the reaction is homogeneous. The flask is then deoxygenated three times with vacuum/nitrogen. The mantle skin temperature is taken to 200°C and the internal temperature of the flask is maintained at 90°C for three and one-half hours using the vacuum regulator to control reflux at that temperature (0.505 to 0.609 bar vacuum). The reaction is cooled at this point by vacuum refluxing.

The thick polymer solution is diluted with dioxane containing small amounts of ammonium hydroxide and methanol and precipitated by slow addition to 6 volumes of 10:1 methanol:ammonium hydroxide under high-shear agitation. The precipitated polymer is isolated by filtration, washed with methanol, and dried under vacuum. The nickel content of the polymer is further reduced by acid extraction. The dry polymer is dissolved in 1.5 l of toluene and extracted with 5% aq. HCl (3 X 300 ml) and water (2 X 500 ml), dried with MgSO₄, and filtered once again. The resulting polymer solution is precipitated by slow addition to 5 volumes of rapidly stirred methanol and the polymer isolated by filtration, washed with methanol, and dried in a vacuum oven at 50°C to yield 248 grams of poly(ethynylphenyl-ether) (PEPE).

A 40 wt% solution of PEPE in 1,3-dimethoxybenzene is prepared. This solution is filtered through a 0.5 μm Fluoropore® filter and then placed on a trench-containing silicon wafer. (Fluropore is the trademark of Millipore Corporation.) The wafer is spun at 4000 rpm for 60 seconds and placed on a 80°C hot plate under nitrogen. The hot plate is heated to 425°C and held at that temperature for 60 minutes. Then the hot plate is cooled to room temperature and the wafer is removed. This process results in a wafer demonstrating no unfilled gaps and excellent surface planarity from the 3 µm PEPE film.

Example 2

Set up a 1-liter, 4-necked round-bottomed flask with a heating mantle, overhead stirrer, a powder funnel and two matched reflux condensers each with a nitrogen/vacuum inlet. Connect the inlets via a manifold to a valve connected to nitrogen and a vacuum system. The vacuum system should have a regulator. Blow nitrogen through the system as the flask is charged through the powder funnel with 78.20 g (0.50 mol, 1.50 mol of ethynyl groups) of triethynylbenzene (TEB, 96%), 110.22 g (0.50 mol, 1.00 mol of ethynyl groups) of diethynyl diphenylether (DEDPE, 99%), 1.83 g (6.25 mmol) of nickel 2,4-pentanedionate dihydrate and 4.60 g (17.5 mmol) of triphenylphosphine. Rinse the powders in with 222 ml (2.02 mol) of phenylacetylene (PA) and rinse the PA in with 368 ml of dioxane. The reaction is now 50% by weight in monomers. Replace the powder funnel with a thermowell and stir the reaction until it is homogeneous.

Deoxygenate the reaction mixture three times with nitrogen, then heat the rapidly stirred solution quickly (≤15 minutes) to 75°C. From 70 to 75°C pull a vacuum on the system to regulate the reflux at 75°C.

When the desired molecular weight range is reached, refluxively cool the reaction to room temperature. Strip off the dioxane under vacuum. Redissolve the residue in 500 ml methylene chloride. Wash the organic solution with 5% HCl (3 x 200 ml) and with deionized water (2 x 200 ml). Dry the organic phase over magnesium sulfate (50 g) and filter through 100 g of silica gel. Strip the solution to a total of 800 g of solution. Add 20 g of diatomaceous earth and 20 g of magnesium sulfate and filter again.

Precipitate the prepolymer by dripping the solution into 10 l of rapidly stirred methanol. Filter the golden yellow solid through a coarse glass frit funnel and then wash the filter cake with 250 ml methanol and briefly suck it dry. Dry the polymer in a vacuum oven at 45-55°C overnight. The expected yield will vary depending upon the reaction time. For a 20 minute reaction, the yield was 113.11 g (29%) of a polymer with $M_w$ of 2,100.

The polymer, single step acetylenic thermoset prepolymer (SSATP), was analyzed by NMR using toluene as an internal standard and the terminal acetylene content was determined to be 9.12 mmole/g. The SSATP (50.0 g, -456 mmoles) and phenylacetylene (1824 mmoles) were placed into a 500 ml dropping funnel and the polymer was allowed to dissolve. Cuprous chloride (43.8 mmoles) and tetramethylethylenediamine (43.8 mmoles) were placed into a two-liter three-necked round bottomed flask and were washed in with 400 ml of chloroform. The flask was equipped with a magnetic stirrer, thermocouple, oxygen aspirator tube and the dropping funnel topped with a dry ice condenser. The catalyst solution was stirred and oxygen was introduced through the aspirator tube. The solution was brought to 28°C using a mantle skin temperature of 30°C. The polymer solution was quickly added. A slow exotherm took the reaction temperature to 38°C over a period of thirty minutes. The reaction was kept at 28°C overnight.

The reaction mixture was placed into a two liter separatory funnel. The polymer solution was washed with 10% hydrochloric acid (3 X 400 ml) and deionized water (2 X 400 ml). After drying over magnesium sulfate, the solution was filtered and rotary evaporated to dryness. The polymer was redissolved in methylene chloride and eluted with methylene chloride through a 250 g silica gel column. The polymer solution was then rotary evaporated to 500 g and 10 g each of magnesium sulfate and diatomaceous earth were added. After filtration, the polymer solution was precipitated slowly into 10 liters of rapidly stirring methanol. The slurry was filtered and the cake was washed with 500 ml of methanol and dried in a vacuum oven at 40°C to yield 64.23 g of bis-acetylene terminated single step acetylenic thermoset polymer (BAT-SSATP).

A 40 wt% solution of BAT-SSATP in N-methylpyrrolidinone was prepared. This solution was filtered through a 0.5 µm Fluoropore® filter and then placed on a trench-containing silicon wafer. The wafer was spun at 4000 rpm for 40 seconds and placed on an 80°C hot plate under nitrogen. After 30 minutes, the hot plate was heated to 100°C and held at that temperature for 30 minutes. This stepwise heat/hold cycle was repeated at 125, 200, 300 and 425°C. The hot plate was cooled to 400°C and held at that temperature for four hours. Then the hot plate was cooled to room temperature and the wafer was removed. This process yielded a wafer demonstrating no unfilled gaps and excellent surface planarity from the 1 µm BAT-SSATP film.

Example 3

The polymer PEPE, prepared as in Example 1, was analyzed by NMR using toluene as an internal standard and the terminal acetylene content was determined to be 1.04 mmol/g. 10 g of the polymer, 2.4 ml iodobenzene (21.6 mmol), 540 mg triphenylphosphine (.21 mmol), 410 mg cupric acetate monohydrate (.21 mmol), 370 mg palladium chloride (.21 mmol), 6.6 ml t-butylamine (62 mmol) and 100 ml THF were placed in a 1-liter round bottomed flask equipped with a heating mantle, reflux condenser, nitrogen/vacuum inlet, overhead stirrer, and a thermowell. The contents were stirred and deoxygenated three times with nitrogen. The flask was taken to reflux overnight. After cooling to room temperature, the polymer solution was rotary evaporated to remove the solvents, redissolved in 60 ml chloroform, and washed with 10% hydro chloric acid (3 x 40 ml) and deionized water (2 x 50 ml). The solution was dried over magnesium sulfate and precipitated into 3 l of methanol. The polymer slurry was filtered, washed with methanol and dried in a vacuum oven to yield 8.3 g of polymer, (Tolan - PEPE).

The Tolan-PEPE described in the above paragraph was also prepared directly by reacting tolan capped monomers. Tolan-capped diethynyldiphenylether was prepared by reacting iodobenzene with DEDPE and partially separating the monomers. The partially-capped DEDPE and phenylacetylene were then cyclotrimerized until no further reaction was apparent by infrared techniques. This process provided a PEPE-like polymer with tolan reactive sites and very few terminal acetylenes.

Example 4 - Monomer Synthesis

In a 1000 ml 3-neck round bottom flask equipped with mechanical stirrer, condenser and nitrogen inlet was placed 4,4'-diethynyldiphenylether (DEDPE) (68.4 g, 300 mmol), triethylamine (110 ml) and iodobenzene (30.6 g, 150 mmol). The mechanically stirred suspension was warmed in a warm water bath until a homogeneous solution resulted and this solution was deoxygenated with a stream of nitrogen as the solution cooled back to room temperature. The catalysts, bis(triphenylphosphine) palladium dichloride (52 mg, 0.07 mmol) and tris(triphenylphosphine) copper(I) chloride (72 mg, 0.07 mmol), were then added and the resulting mildly exothermic reaction was moderated with a water bath. The white slurry was mechanically stirred for two hours and more catalyst was added (equal to the initial amounts) and the reaction continued for six hours more. After this time the flask was fitted with a short-path distillation head and the excess triethylamine was removed under house vacuum with warming to give a solid residue to which was added methanol (200 ml) and the solid was dispersed with stirring. To this vigorously stirred suspension was added water (200 ml) over five minutes and 10% aqueous HCl (300 ml) over 10 minutes. Upon completion of HCl addition the slurry was stirred an additional 10 minutes and was then suction filtered and the white solid washed with 10% aqueous HCl (200 ml) and water (400 ml). The solid was air dried on the filter overnight and was then transferred to a 2000 ml Erlenmeyer flask with the aid of warm isooctane (500 ml). The resulting slurry was brought to a boil and silica gel (20 g) and magnesium sulfate (10 g) were added and then the hot solution was gravity filtered through a pad of silica gel which was then washed with additional hot isooctane (300 ml). The filtrate was concentrated by rotary evaporation to a cream-colored solid, 60.0 g, which was found to be a 55:45 (mol%) mixture of 4-ethynylphenyl-4'-phenylethynylphenyl ether and 4,4'-diethynyldiphenylether by both NMR and reverse phase chromatographic analysis.

## Polymer Synthesis

10 g of the tolan-capped monomer mixture from the paragraph above (assayed to be 45% DEDPE and 55% of the mono-tolan-capped DEDPE) was combined with 3.66 g DEDPE to give a 2:1 mixture of DEDPE to tolan-DEDPE (37.4 mmol: 18.7 mmol). Phenylacetylene (2.05 ml, 18.7 mmol), nickel acetylacetonate (310 mg, .105 mmol), triphenylphosphine (75 mg, .28 mmol) and 15 ml dioxane were all added to a 100 ml round bottomed flask equipped with a heating mantle, overhead stirrer, thermowell, reflux condenser, nitrogen/vacuum inlet, vacuum regulator and reflux condenser. The reaction was monitored for the disappearance of ethynyl by infrared spectroscopy. The reaction was run at 90°C for 7 hours at which time no further reaction appeared to occur. The reaction was diluted with 30 ml dioxane and directly precipitated into 1400 ml methanol. The slurry was filtered and dried overnight in a vacuum oven to yield 13.08 g (84% yield) of a polymer with a $M_w$ of 17,000.

## Example 5

Preparation of a "Thermal Polymer" from DEDPE (4,4'-diethynyldiphenyl ether) and PA (phenylacetylene)

In a 1000 ml round-bottomed 3-neck flask equipped with reflux condenser, nitrogen inlet, mechanical stirrer and internal thermocouple was placed DEDPE (160 g), PA (7.3 g) and diglyme (240 g). The resulting solution was stirred and heated and aliquots were occasionally removed from the solution and their viscosity was determined at room temperature. The solution was maintained at reflux (~162°) for 120 minutes, gradually cooled to 151° over the next 90 minutes and then maintained at this temperature for an additional 70 minutes until the desired viscosity of 52 cs was obtained. Polymerization was then terminated by simply cooling the solution to room temperature and the material was precipitated by dropwise addition of the diglyme solution into a rapidly stirred ten-fold excess of methanol. The solid was collected by filtration and weighed 107 g (~65% of theoretical) after it was dried in a stream of nitrogen.

## Example 6

Trench Fill Processing with a "Thermal Polymer"

The dried "Thermal Polymer" from Example 5 was reformulated as a 30% (by weight) solution in NMP (N-methylpyrrolidinone) having a viscosity of 3.11 x $10^{-4}$m$^2$/s and a GPC molecular weight profile of $M_n$ 2,500, $M_w$ 251,000 and $M_z$ 1,390,000. The NMP solution was filtered through a 0.5 μm filter onto trench silicon substrates and spin-coated at 4000 rpm for 40 seconds to give a 2.0 μm film.

The resulting film was cured on a hot plate under an inert atmosphere in a stepwise fashion: 160° to 210° at 5°/minute, isothermal at 210° for 60 minutes, 210° to 400° at 10°/minute and finally isothermal at 400° for 240 minutes. Examination of the substrate by SEM indicated completely filled trenches and excellent substrate planarization.

## Example 7

Trench-fill Procedure

A 30 to 70 wt% solution of an aromatic acetylene oligomer (PEPE) in an appropriate solvent was prepared. This solution was filtered through a 0.5 μm Fluoropore® filter and then placed on a trench-containing silicon wafer. The wafer was spun at 3000-10,000 rpm for 40-60 seconds and placed on an 80°C hot plate under nitrogen. The hot plate was ramped to the selected cure temperature at a rate of 10° per minute. The cure temperature was held for a period of time (30 minutes - 4 hours) to assure full cure and then the hot plate was cooled to room temperature and the wafer was removed. This process resulted in a wafer demonstrating no unfilled trenches and excellent surface planarity from the 1 to 10 μm PEPE film.

## Example 8

1. Trenched wafers are coated with 35% PEPE in xylene (filtered to 0.45 μm) and spun on at 3000 rpm, giving a thickness of 2.8 μm on blanks.

2. PEPE-coated wafers are put on a 50° hotplate, ramped at 9.9°/minute to 400°, then held at 400° for 30 minutes.

3. The wafers are then etched to endpoint + 10%. Etching was done here in a Tegal RIE system, at 20 sccm flow of $O_2$, 100 watts R$_f$, 5-10 watts reflected, and pressure of 113 - 120 μbar.

4. The wafers are dipped in HF, rinsed and dried before recoating. They can be dried by dipping in isopropanol after rinsing, spinning dry, and then baking at 100° for 15 minutes.

5. The wafers are again coated with 35% PEPE in xylene (filtered to 0.45 µm), spun on at 3000 rpm.

6. PEPE-coated wafers are put on a 50° hotplate, ramped at 9.9°/minute to 400°, then held at 400° for 30 minutes.

7. The wafers are again etched to endpoint.

8. PEPE-coated wafers are put on a 50° hotplate, ramped at 9.9°/minute to 425°, held at 425° for 60 minutes.

9. SEM shows well filled trenches and excellent planarization.

**Claims**

1. Process for filling deep dielectric isolation trenches in a semiconductor device, said process comprising the steps of:

(1) dissolving a polyaromatic oligomer with reactive ethynyl groups in a solvent to form a solution of viscosity between 2 x $10^{-6}$ and 2 x $10^{-3}$ m2/s

(2) filtering said solution,

(3) coating the trench-containing semiconductor device with said solution to form a film,

(4) evaporating the solvent, and

(5) heating and curing the film.

2. Process as claimed in claim 1 wherein the dielectric isolation trenches are about 1 to 2 µm in width and about 5 µm in depth.

3. Process as claimed in claim 1 wherein the oligomer melts, flows and fills the trenches after the solvent evaporates, and then polymerizes by the reaction of the ethynyl groups.

4. Process as claimed in claim 3 wherein the resulting polymer is thermally stable, planarizable, solvent and moisture resistant, and has a high glass transition temperature.

5. Process as claimed in claim 1 wherein the semiconductor is silicon.